# EUROPEAN PATENT SPECIFICATION

(11) **EP 2 730 677 B1**
(45) Date of publication and mention of the grant of the patent: **28.09.2016**
(21) Application number: 12806892.1
(22) Date of filing: 05.07.2012
(51) Int. Cl.: C23C 16/458, C23C 16/509, C23C 16/515, H01J 37/32, H01L 21/67, H01L 21/687, C23C 14/32, C23C 14/34, C23C 14/50

(54) **VACUUM FILM FORMATION DEVICE**
VAKUUMFILMBILDUNGSVORRICHTUNG
DISPOSITIF DE FORMATION DE FILM SOUS VIDE

(30) Priority: 06.07.2011 JP 2011150145; 26.08.2011 JP 2011184819
(43) Date of publication of application: 14.05.2014
(73) Proprietor: Kabushiki Kaisha Kobe Seiko Sho, Chuo-ku Kobe-shi Hyogo 651-8585 (JP)
(72) Inventor: TAMAGAKI, Hiroshi, Hyogo 676-8670 (JP); HAGA, Junji, Hyogo 676-8670 (JP)
(74) Representative: TBK
(86) International application number: PCT/JP2012/004354
(87) International publication number: WO 2013/005435

(56) References cited:
- JP-A- 63 262 472
- JP-A- 2004 323 883
- JP-A- 2007 308 758
- JP-A- 2009 179 870
- US-A1- 2006 014 041

## Description

### TECHNICAL FIELD

The present invention relates to a vacuum coating apparatus that realizes a vacuum coating method (for example, an ion plating method (including an AIP method), a sputtering method, a plasma CVD method, and a combination thereof) of applying a voltage to plural substrates under a vacuum condition so as to deposit a thin film on the substrates.

### BACKGROUND ART

Since 1980s, a hard coating made from TiN or TiAlN has been deposited on a substrate according to a vacuum coating method such as an AlP (Arc Ion Plating) method and a sputtering method in order to improve the lifetime of a cutting tool. Further, in recent years, a wear resistance coating of CrN or DLC (Diamond-Like-Carbon) has been actively performed on a metallic mechanical component such as a piston ring and a vehicle engine component in order to improve the wear resistance and the seizure resistance of the surface.

An apparatus that performs such a vacuum coating process is used for the purpose of uniformly processing plural substrates (components) at one time. Specifically, the substrates are mounted (held) on a rotating table (using a jig or the like if necessary), and a coating is deposited on the substrates while a voltage for generating a plasma or adjusting a coating quality is applied to the respective substrates.

For example, Patent Document 1 discloses a coating apparatus that includes a plasma generation unit, a multi-cusped magnetic field generation unit, and a holding and rotating unit. The plasma generation unit generates plasma inside a vacuum chamber in which a substrate as a coating subject is disposed. The multi-cusped magnetic field generation unit generates a multi-cusped magnetic field that confines the plasma generated by the plasma generation unit inside a space (a confinement space) near the substrates. The holding and rotating unit holds the substrate and rotates the substrate about the vicinity of the center of the confinement space as the center axis. In the coating apparatus, all substrates are connected to one electrode of the power supply through the table on which the substrates are placed, so that a bias voltage is applied thereto. These substrates generate a glow discharge by using the vacuum chamber of a ground potential as a counter electrode in a manner such that the substrates are connected to the other electrode of the power supply, so that plasma is generated. Then, a source gas is decomposed by the plasma, so that a coating is deposited on the surfaces of the substrates.

Further, Patent Document 2 discloses a plasma CVD apparatus that deposits a coating on a surface of a process subject (a substrate) according to a plasma CVD method. The plasma CVD apparatus includes a vacuum chamber, a plasma generation unit, a reflection unit, and a source gas introduction unit. The process subject is disposed inside the vacuum chamber. The plasma generation unit generates plasma inside the vacuum chamber. The reflection unit is installed so as to face the plasma generation unit inside the vacuum chamber, and reflects the plasma toward the plasma generation unit. The portion that reflects the plasma in the reflection unit is formed by metallic wool. The source gas introduction unit introduces a source gas as a material of a coating into the vacuum chamber. In the plasma CVD apparatus, the process subject (the subject on which the coating is deposited) is connected to a DC power supply, so that a bias voltage is applied thereto. Then, the plasma which is generated at the center portion of the vacuum chamber by a plasma gun decomposes the source gas. At this time, when the bias voltage is applied to the process subject that surrounds the plasma, a coating is deposited.

Further, Patent Document 3 discloses a physical deposition apparatus that includes a vacuum chamber, a revolution table, substrate holders, a sputtering evaporation source, and a bias power supply. The revolution table, the plural substrate holders, and the sputtering evaporation source are disposed inside the vacuum chamber. The revolution table may rotate a rotation axis perpendicular to an installation surface about the rotation center at the center of the installation surface on which the substrate holders are disposed. The plural substrate holders are provided on the installation surface of the revolution table so as to surround the rotation axis. The respective substrate holders are respectively provided on the placement surface in a rotatable state, and hold the substrates. The sputtering evaporation source is disposed at a position facing the substrate holders. The bias power supply is connected to the respective substrate holders. The bias power supply may apply a negative pulsed bias voltage to the respective substrate holders. Accordingly, the same voltage is applied to the substrates held by the respective substrate holders. Further, Patent Document 1 also discloses a configuration in which an arc evaporation source is disposed at a position facing the substrate holders. Here, one bias power supply is provided, and applies the same voltage to the respective substrate holders.

Further, Patent Document 4 discloses an AIP apparatus. In the AIP apparatus, a cylindrical arc evaporation source of an AIP method is disposed at the center inside a cylindrical chamber (along the center axis of the chamber), and plural substrates mounted on a rotation table are disposed in the circumferential direction so as to surround the cylindrical arc evaporation source. The AIP apparatus is configured so that the steam generated in the cylindrical arc evaporation source is supplied from the center of the chamber toward the outside in the radial direction. The cylindrical arc evaporation source is connected to a cathode of the arc power supply and generates an arc spot on the surface thereof so as to evaporate a coating raw material. The arc evaporation source requires anodes operating in pair. For this reason, in the AIP apparatus, since the substrates mounted on the rotation table surround the cylindrical arc evaporation source in the circumferential direction, valid anodes are provided as (1) plural bar-shaped anodes disposed around the cylindrical arc evaporation source or (2) annular anodes disposed near both ends of the cylindrical arc evaporation source.

The coating apparatus disclosed in Patent Document 1 has the following problems.

In the coating apparatus disclosed in Patent Document 1, the coating adheres to the portion other than the substrate of the coating subject, for example, the inner wall of the vacuum chamber and the like. The inner wall of the vacuum chamber is not replaced every time unlike the substrate. For this reason, an insulation coating deposited on the vacuum chamber becomes thickened as the coating process continues. Then, as the coating thickness of the deposited coating increases, the electrical resistance of the inner wall of the vacuum chamber increases. Thus, there is a case in which the generation of the plasma generated by using the inner wall as one electrode becomes unstable or the process is not performed at the optimal condition.

Further, the plasma CVD apparatus disclosed in Patent Document 2 includes a mechanism that generates plasma by a plasma gun and applies a pulsed bias voltage to the substrates revolving in a rotating state inside the vacuum chamber. In this way, when the voltage applied to the substrate is the pulsed voltage, the charge-up of the insulation coating deposited on the surface of the substrate is prevented, so that a stable coating process may be performed. However, even when the voltage applied to the substrate is the pulsed voltage, the insulation coating is deposited on the periphery of the plasma gun, the reflection unit, and the inner wall surface of the grounded vacuum chamber. For this reason, in the plasma CVD apparatus, as in the coating apparatus described in Patent Document 1, the insulation coating becomes thickened as the coating process continues, so that the plasma generated inside the vacuum chamber becomes unstable. For this reason, the components other than the substrate need to be frequently replaced and cleaned.

In addition, even in the coating apparatus described in Patent Document 1 and the plasma CVD apparatus described in Patent Document 2, the coating deposited on the portion other than the substrate becomes easily peeled off and scattered as the coating thickness increases, and hence this state also causes a coating defect. For this reason, there is a need to perform a periodic cleaning process in the coating apparatus and the plasma CVD apparatus. The problem that the periodic cleaning process is required also occurs in a case where a CVD coating is a conductive coating.

Further, in the physical deposition apparatus disclosed in Patent Document 3, the coating process is performed by applying the same voltage to all the substrates held by the respective substrate holders on the revolution table. For this reason, in a single process, the substrates held by the respective substrate holders on the revolution table are coated in the same condition. Such a process does not cause any problem in a case where all the substrates to be processed need to have the same coating quality and all the substrate holders hold (mount) the same amount of substrates. However, since there has been an increasing demand for a small-lot production of various products in recent years, the number of the coating processes in the same condition decreases. For this reason, a chance decreases in which the coating process is performed while the substrates are fully mounted inside the vacuum chamber of the physical deposition apparatus, so that the productivity is degraded.

Further, in the AIP apparatus disclosed in Patent Document 4, the anodes of (1) capture the steam from the cylindrical arc evaporation source and disturb the steam moving toward the substrates, so that the coating speed decreases, that is, the productivity is degraded. Further, the captured steam is deposited on the anodes, and the deposited steam (the coating raw material) is peeled off, so that a coating defect occurs. For this reason, in the AIP apparatus using the anodes of (1), the anodes need to be cleaned frequently, and hence the productivity is degraded. Further, the anodes of (2) may not capture the steam as in the anodes of (1), and may not easily control the arc spot position of the arc discharge when the length of the cylindrical arc evaporation source is long. Thus, it is difficult to mention this apparatus is practical. For this reason, in the actual apparatus, the anodes of (1) are used, so that the productivity is degraded.

### CITATION LIST

### PATENT DOCUMENT

Patent Document 1: JP 2007-308758 A
Patent Document 2: JP 2006-169563 A
Patent Document 3: JP 2004-323883 A
Patent Document 4: JP 1994(H06)-340968 A
Patent Document 5: US 2006/0014041 A1
Patent Document 6: JP 2009 179 870

US 2006/0014041 A1 discloses a coating apparatus having a plurality of planetary rotation holding units that have a plurality of rotation axes parallel to one another for holding a coating subject while rotating about the respective rotation axes; and a table as a revolution mechanism that revolves the plurality of planetary rotation holding units. In one example, among the planetary rotation holding units one planetary rotation holding unit can be used with a first material and one planetary rotation holding unit can be used with a second material.

JP 2009 179 870 discloses a device for deposited film formation in which a first conductor and a second conductor are arranged separate from each other. Pulse-like DC voltage is applied between the first conductor and the second conductor in such a manner that a state in which the potential of the first conductor is higher that that of the second conductor, and a state in which the potential of the second conductor is higher that that of the first conductor, is alternately repeated.

### SUMMARY OF THE INVENTION

An object of the present invention is to provide a vacuum coating apparatus capable of keeping a stable coating condition even when the vacuum coating apparatus is used for a long period of time, preventing a deposition on a portion other than a substrate, and uniformly depositing a coating on plural substrates at one time even in different coating conditions.

This object is solved by a vacuum coating apparatus having the features of claim 1. Further developments are stated in the dependent claims.

### BRIEF DESCRIPTION OF DRAWINGS

[Fig. 1] Fig. 1 is a perspective view illustrating a vacuum coating apparatus (a plasma CVD apparatus) according to a first embodiment.
[Fig. 2] Fig. 2 is a diagram illustrating a power supply connection example of the vacuum coating apparatus of Fig. 1.
[Fig.3] Fig. 3 is a diagram illustrating an installation example of a substrate in a rotation holding unit.
[Fig.4] Fig. 4 is a schematic diagram illustrating a cross-section of the vicinity of a rotational driving unit in the vacuum coating apparatus of Fig. 1.
[Fig. 5] Fig. 5 is a diagram illustrating the arrangement of the rotation holding unit in a revolution table.
[Fig. 6] Fig. 6 is a perspective view illustrating a vacuum coating apparatus (an AIP apparatus equipped with an arc evaporation source) according to a second embodiment.
[Fig.7] Fig. 7 is a diagram illustrating a power supply connection example of the vacuum coating apparatus of Fig. 6.
[Fig.8] Fig. 8 is a diagram illustrating a power supply connection example of a vacuum coating apparatus (an AIP apparatus equipped with a cylindrical arc evaporation source) according to a third embodiment.
[Fig. 9] Fig. 9 is a timing chart illustrating a power supply connection of the vacuum coating apparatus of Fig. 8.

### DESCRIPTION OF EMBODIMENTS

Hereinafter, embodiments of a vacuum coating apparatus according to the present invention will be described in detail by referring to the drawings. Furthermore, in the description below, the same reference numerals will be given to the same components even in the different embodiments. Such components have the same name and the same function. Accordingly, the detailed description of the components will not be repeated.

### <First Embodiment>

### [Overall Configuration]

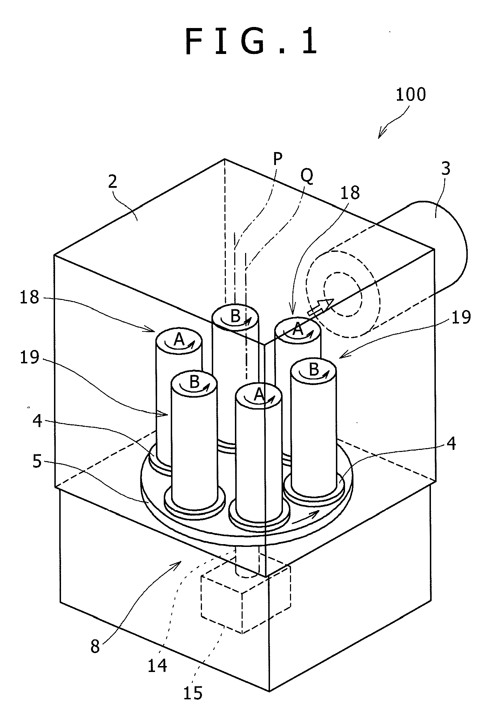

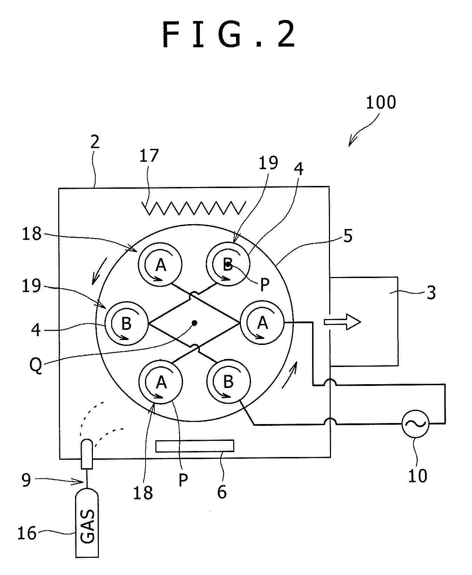

Fig. 1 illustrates an overall configuration of a plasma CVD apparatus 100 as an example of a vacuum coating apparatus of the present invention. Fig. 2 is a power supply connection example of the plasma CVD apparatus 100.

The plasma CVD apparatus 100 includes a vacuum chamber 2, a vacuum exhaust unit 3, and plural rotation holding units 4. The vacuum exhaust unit 3 changes the inside of the vacuum chamber 2 into a vacuum exhaust state. The respective rotation holding units 4 hold a substrate W as a coating subject. Further, the respective rotation holding units 4 rotate while holding the substrate W. The plural rotation holding units 4 are disposed on a revolution table 5 so that the rotation axes of the respective rotation holding units 4 are parallel to one another. The plasma CVD apparatus 100 includes a revolution mechanism 8. The revolution mechanism 8 causes the revolution table 5 equipped with the plural rotation holding units 4 to revolve about the rotation axis (the revolution axis Q) parallel to the rotation axis (the spinning axis P) of each rotation holding unit 4. By such a revolution mechanism 8, a uniform coating process is performed on the substrate W while the substrate rotates and revolves at the same time. Such a mechanism is generally referred to as a rotating and revolving mechanism, a planetary rotation mechanism, or a two-fold rotation mechanism.

Furthermore, in the present invention, the "state where the rotation holding unit 4 rotates" indicates that the rotation holding unit 4 rotates (spins) about the spinning axis P penetrating the rotation holding unit 4. Further, the "state where the rotation holding unit 4 revolves" indicates that the rotation holding unit 4 rotates about the revolution axis Q separated therefrom, that is, the rotation holding unit 4 moves around the revolution axis Q.

The configuration of the plasma CVD apparatus 100 will be described in more detail.

The vacuum chamber 2 is a casing that may seal the inside thereof from the outside. The side of the vacuum chamber 2 is provided with a vacuum pump 3 (a vacuum exhaust unit). The vacuum pump 3 discharges a gas inside the vacuum chamber 2 to the outside so that the inside of the vacuum chamber 2 becomes a low-pressure state (a vacuum state or a substantial vacuum state). The vacuum pump 3 may decrease the pressure inside the vacuum chamber 2 to the vacuum state. And, the plural substrates W are accommodated inside the vacuum chamber 2 while being respectively held by the rotation holding units 4.

In order to perform a uniform coating process, the substrates W on which the coating process is performed by the plasma CVD apparatus 100 of the first embodiment are disposed inside a columnar space which is long in the vertical direction.

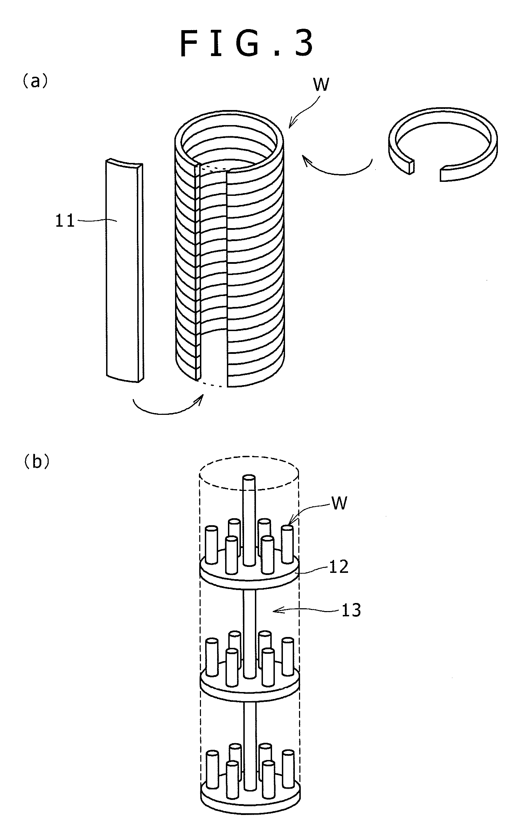

For example, in a case where the substrate W is a piston ring illustrated in Fig. 3(a), the respective substrates W are provided in the rotation holding units 4 so as to be coated in a substantially cylindrical shape as illustrated in Fig. 3(a). In a case where the respective substrates W are coated, when the substrates are not coated in a complete cylindrical shape of which a part in the circumferential direction lacks (is opened) as illustrated in Fig. 3(a), the opening window is covered by a cover 11. Accordingly, the uniform coating process may be performed.

Further, when the substrate W as the coating subject is a small member (for example, a small piston pin) illustrated in Fig. 3(b), an installation jig 13 is prepared in which plural disks 12 are disposed in the vertical direction with a gap therebetween, and the respective substrates W are disposed in the respective disks 12. The installation jig 13 is formed so as to be received inside the columnar space. The substrate mounted state illustrated in Fig. 3(b) may be applied to a case where the substrate W is a shaft-like tool such as a drill or an end mill. More desirably, the installation jig 13 is formed so that each substrate W individually rotates while being mounted on the installation jig 13.

Further, when the substrate W is an object other than the above-described object, the installation jig is appropriately manufactured so that the installation jig and the substrates W mounted on the installation jig are received inside the columnar space.

The rotation holding unit 4 is, for example, a circular placement table of which the upper surface is horizontal. The rotation holding unit 4 is rotatable about the rotation axis (the spinning axis P) extending in the vertical direction. Accordingly, the rotation holding unit 4 may hold the substrate W disposed on or above the rotation holding unit 4 while rotating the substrate about the rotation axis (the spinning axis P). The rotation holding unit 4 is formed so that a voltage may be supplied thereto, and the voltage supplied thereto is applied to each substrate W through the rotation holding unit 4.

In a case of the plasma CVD apparatus 100 illustrated in Fig. 1, six rotation holding units 4 are disposed. The six rotation holding units 4 are disposed on the upper surface of the revolution table 5 so as to be lined up in one circle in the top view. The six rotation holding units 4 are divided into a group A and a group B.

The center axis (the revolution axis Q) of the revolution table 5 extends in the vertical direction. Then, the revolution table 5 rotates about the revolution axis Q. As described above, plural (six) rotation holding units 4 are lined up at an interval in the circumferential direction about the revolution axis Q in the upper surface of the revolution table 5. Specifically, plural rotation holding units 4 are disposed on the upper surface of the revolution table 5 so that the distance (the radius) from the revolution axis Q of the revolution table 5 are uniform and the rotation holding units are lined up at the same interval about the revolution axis Q (in the circumferential direction). The revolution mechanism 8 which rotates the revolution table 5 about the revolution axis Q is provided below the revolution table 5.

The revolution mechanism 8 includes a shaft 14 and a rotational driving unit 15. The shaft 14 extends downward along the revolution axis Q from the lower surface of the revolution table 5. The rotational driving unit 15 rotationally drives the shaft 14. When such a revolution mechanism 8 rotates the revolution table 5 about the revolution axis Q, the rotation holding units 4 holding the substrates W rotate (revolve) about the revolution axis Q. Since the rotation holding unit 4 rotates about its axis center (the spinning axis P) in a revolving state, the substrate W held by the rotation holding unit 4 rotates about the spinning axis P along with the rotation holding unit 4.

By such a mechanism, a coating is deposited on the substrates W inside the vacuum chamber 2 in a manner such that the substrates rotate (revolve in a rotating state) along with the rotation holding unit 4 about the revolution axis Q by the revolution table 5 while the substrates rotate about the spinning axes P by the respective rotation holding units 4.

Furthermore, the substrates W which are held by the respective rotation holding units 4 are installed so as to prevent any interference therebetween when the substrates revolve in a rotating state by adjusting the sizes of the adjacent substrates W in consideration of the phase by the rotation of the rotation holding units 4.

Further, the plasma CVD apparatus 100 includes a gas supply unit 9 and a plasma generation power supply 10. The plasma CVD apparatus 100 deposits a coating on the substrate W held by the rotation holding unit 4 using a plasma CVD method. The gas supply unit 9 supplies a process gas containing a source gas into the vacuum chamber 2. The plasma generation power supply 10 is an AC power supply. The plasma generation power supply 10 generates a plasma in the process gas supplied into the vacuum chamber 2 in a manner such that the rotation holding units 4 of two groups A and B are connected to both electrodes thereof (specifically, the rotation holding unit 4 of the group A is connected to one output electrode of the plasma generation power supply 10 and the rotation holding unit 4 of the group B is connected to the other output electrode of the plasma generation power supply 10).

The gas supply unit 9 includes a cylinder 16, and supplies a source gas necessary for the CVD coating and an assist gas assisting the coating process by a predetermined amount from the cylinder 16 into the vacuum chamber 2.

In a case where a carbon CVD coating is deposited by DLC (Diamond-Like-Carbon and amorphous carbon film), the process gas is generated by adding an inert gas (argon, helium, or the like) as an assist gas to a source gas containing, for example, hydrocarbon (acethylene, ethylene, methane, ethane, benzene, toluene, or the like). Further, in a case where a CVD coating (SiOx film, SiOC film, SiNx film, or SiCN film) is formed by a silicon compound, the process gas is generated by adding a reactive gas such as oxygen and an inert gas such as argon as an assist gas to, for example, a source gas containing a silicon-based organic compound (monosilane, TMS, TEOS, HMDSO, or the like) or silicon such as silane. Furthermore, the plasma CVD apparatus 100 may deposit a TiOx film, an AlOx film, an AlN film, or the like as the CVD coating other than those described above.

Further, a small amount of addition source gas may be mixed with a main source gas. For example, a coating containing Si in DLC is deposited by adding a small amount of a silicon-based organic compound gas to hydrocarbon as a main source gas when depositing a DLC coating. Alternatively, a coating containing metal (for example, titanium) in DLC is deposited by adding a small amount of a source gas (for example, TiPP (titanium isopropoxide) or TDMAT (tetradimethylaminotitanium) to hydrocarbon as a main source gas when depositing the DLC coating.

Furthermore, the source gas, the reactive gas, and the assist gas may be obtained by appropriately combining various gases.

Further, as illustrated in Fig. 2, a different coating supply source 6 (a sputtering source, an arc evaporation source, or the like) may be provided inside the vacuum chamber 2.

Further, a heating heater 17 may be appropriately disposed inside the vacuum chamber 2. The heating heater 17 adjusts the coating quality of the coating deposited on the substrate W by adjusting the temperature of the substrate W.

Hereinafter, a rotation mechanism and a power feeding mechanism will be described in detail.

### [Power Feeding Mechanism and Rotation Mechanism]

The plasma generation power supply 10 generates plasma by causing a glow discharge while the process gas is supplied into the vacuum chamber 2. The plasma generation power supply 10 supplies AC power. The power supplied from the plasma generation power supply 10 may be AC power of which positive and negative states of a current and a voltage change in response to a waveform of a sine wave or AC power of a rectangular wave of which positive and negative states change in response to a pulsed waveform. Further, AC power in which a pulse group having the same continuous polarity alternately appears or AC power in which a rectangular wave is superimposed on the AC power of a sine wave may be used as the AC power. Furthermore, there is a case in which the waveforms of the voltage and the current of the AC power in the actual plasma generation state may be deformed due to the influence of the generation of the plasma. Further, when the plasma is generated, the zero level of the AC voltage is shifted. For this reason, when the potential of each output electrode with respect to the ground potential is measured, it is observed that 80 to 95% of the application voltage is applied to the cathode and 5 to 20% of the application voltage is applied to the anode. In the plasma generation state, the cathode attracts positive ions in the plasma, and electrons are emitted by the impact of the positive ions so as be supplied into the plasma. In this way, the cathode becomes a working electrode that plays primary role to generate the glow discharge plasma. The anode becomes a counter electrode for generating the glow discharge plasma while attracting the electrons in the plasma.

The frequency of the AC power supplied from the plasma generation power supply 10 is desirably 1 kHz to 1 MHz. When the frequency of the AC power is lower than 1 kHz, the charge-up of the coating easily occurs. Further, when the frequency of the AC power exceeds 1 MHz, it is difficult to realize a mechanism that transmits power to the substrate W held by the rotation holding unit 4 which revolves in a rotating state. Further, it is more preferable that the frequency of the AC power be in the range of 10 kHz to 400 kHz in consideration of the availability and the like of the power supply. Further, the AC power supplied from the plasma generation power supply 10 is desirably 300 to 3000 V necessary for keeping the glow discharge at the peak value of the voltage. Further, the AC power supplied from the plasma generation power supply 10 changes by the surface area of the substrate W, but may have power density of about 0.05 to 5 W/cm² in the power per unit area.

When the AC power having the frequency, the voltage, and the power density is supplied between a pair of electrodes disposed inside the vacuum chamber 2, the glow discharge is generated between the electrodes, so that the plasma is generated. Then, when the process gas supplied into the vacuum chamber 2 is decomposed according to the plasma, a component of a decomposed source gas or the like is deposited on the surface of the electrode, so that a CVD coating is deposited. That is, when the substrate W is used for any one of the pair of electrodes, the CVD coating is deposited on the surface of the substrate W.

Incidentally, as illustrated in Fig. 2, in the plasma CVD apparatus 100 of the present invention, the half of the plural rotation holding units 4 are connected to one output electrode of the plasma generation power supply 10 so as to form a first group 18. Further, the other half of the plural rotation holding units 4 are connected to the other output electrode of the plasma generation power supply 10 so as to form a second group 19. That is, the rotation holding units 4 of the first group 18 and the rotation holding units 4 of the second group 19 have different polarities. For this reason, plasma is generated between the substrates W held by the rotation holding units 4 of the first group 18 and the substrates W held by the rotation holding units 4 of the second group 19.

Specifically, in a state where six rotation holding units 4 are disposed on the revolution table 5, the number of the rotation holding units 4 of the first group 18 indicated by "A" of Fig. 2 is three and the number of the rotation holding units 4 of the second group 19 indicated by "B" of Fig. 2 is three. That is, in this embodiment, the number of the rotation holding units 4 of the first group 18 is equal to that of the rotation holding units 4 of the second group 19.

With regard to the rotation holding units 4, the rotation holding units 4 of the second group 19 are respectively provided at both sides of the rotation holding unit 4 of the first group 18, and the different rotation holding units 4 belonging to the first group 18 are provided near the rotation holding unit 4 of the second group 19. That is, the rotation holding units 4 of the first group 18 and the rotation holding units 4 of the second group 19 are alternately lined up around the revolution axis Q of the revolution table 5.

Then, three rotation holding units 4 belonging to the first group 18 are all connected to one output electrode of the plasma generation power supply 10. Further, three rotation holding units 4 belonging to the second group 19 are all connected to the other output electrode of the plasma generation power supply 10. That is, the rotation holding unit 4 of the first group 18 and the rotation holding unit 4 of the second group 19 normally have opposite polarities during the application of the voltage.

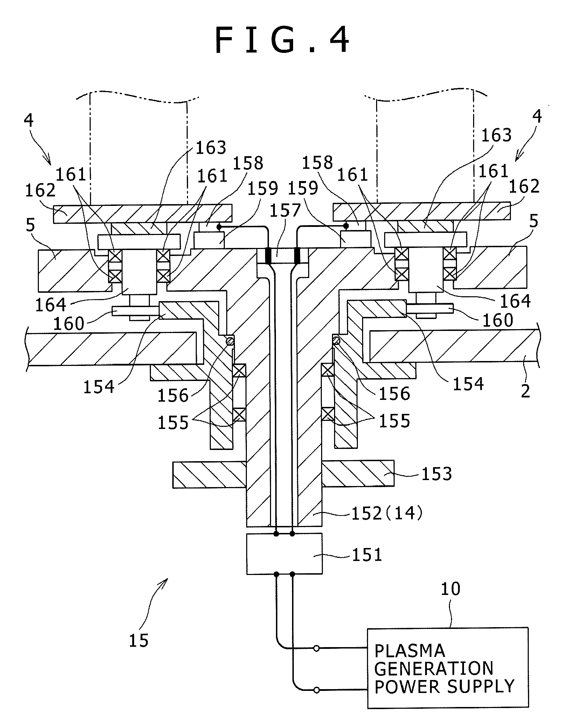

Fig. 4 is a schematic diagram illustrating the cross-section of the vicinity of the rotational driving unit 15 of the plasma CVD apparatus 100.

The revolution table 5 of the plasma CVD apparatus 100 is connected to the bottom surface of the vacuum chamber 2. Specifically, the revolution table 5 is attached to the vacuum chamber 2 so as to be rotatable (revolvable) through a revolution bearing 155 and a rotation shaft seal 156. Further, the revolution table 5 is attached to the vacuum chamber 2 so as to keep the vacuum state inside the vacuum chamber 2 even in the rotation (revolution) state. Then, the revolution table 5 revolves by using the revolution axis Q as the rotation axis through a mechanism such as a drive gear 153 (or a pulley). Furthermore, the revolution table 5 is adapted to rotate along with a shaft 152 (14).

Plural (in this embodiment, six) spinning shafts 164 are attached to the revolution table 5 through a spinning bearing 161. The respective spinning shafts 164 respectively support the rotation holding units 4 so as to rotate about the spinning axis P as the rotation axis. The spinning shaft 164 includes a gear 160, and the gear 160 engages with a fixed gear 154. Accordingly, when the spinning shaft 164 revolves about the revolution axis Q by the rotation (the revolution) of the revolution table 5, the spinning shaft 164 spins about the spinning axis P by the engagement between the fixed gear 154 and the gear 160. By the spinning of the spinning shaft 164, the rotation holding unit 4 rotates about the spinning axis P as the rotation axis. Furthermore, the fixed gear 154 is provided at the inside of the spinning shaft 164 (the side of the revolution axis Q) in Fig. 4, but may be provided at the outside thereof.

A spinning table 162 (in the drawings, a disk shape) used to directly hold (mount) the substrate W thereon is provided at the upper portion of the spinning shaft 164 through an insulator 163. The AC power is supplied from the plasma generation power supply 10 to the spinning table 162 through a brush 158. Furthermore, the revolution table 5 and the brush 158 are insulated from each other by an insulation member 159. There is no electrical connection between the spinning tables 162 through the revolution table 5.

A voltage feedthrough 157 is provided at the center portion of the revolution table 5. The voltage feedthrough 157 supplies the AC power supplied from the lower side of the revolution table 5 to the upper side of the revolution table 5 while the vacuum state inside the vacuum chamber 2 is kept and the lower and upper sides of the revolution table 5 are electrically insulated from each other. The supplied AC power is supplied to the brush 158 by the wiring. The AC power is supplied from the brush 158 to the spinning table 162, and then is supplied from the spinning table 162 to the substrate W. Through such paths, the AC power is supplied to the substrate W.

The brushes 158 which supply the AC power to the respective spinning tables 162 exist as many as the number of the rotation holding units 4 provided in the revolution table 5. As described above, the AC power of different opposite polarities is supplied to each group. Accordingly, the voltage feedthrough 157 includes electrodes which are provided as many as the number of the above-described groups. The voltage feedthrough 157 supplies the AC power from the plasma generation power supply 10 to the plasma generation power supply 10 through a slip ring 151 in a rotatable state.

Furthermore, the brush mechanisms are respectively provided in the shaft 152 of the revolution table 5 and the spinning shaft 164 of the rotation holding unit 4 so that the respective rotation holding units 4 have the above-described polarities, and the voltages of the respective polarities are applied thereto through the brush mechanisms. The spinning shaft 164 is rotatably held by the revolution table 5 through the spinning bearing 161, but a voltage may be applied through the spinning bearing 161.

### [Coating Method]

A coating process using the above-described plasma CVD apparatus 100 will be described. In the plasma CVD apparatus 100, six rotation holding units 4 are disposed at the interval of 60° in the circumferential direction about the revolution axis Q on the revolution table 5 disposed inside the vacuum chamber 2.

First, the substrates W are set on the respective rotation holding units 4, and the exhaust operation is performed until the inside of the vacuum chamber 2 becomes a high vacuum state. Next, if necessary, an inert gas such as Ar and a gas such as H₂ or O₂ are supplied from the gas supply unit 9 into the vacuum chamber 2, and the plasma generation power supply 10 supplies power so as to generate a surface cleaning glow discharge between the substrates W (an ion bombardment process). Further, a pre-heating process may be performed on the substrate W held by the rotation holding unit 4 revolving in a rotating state by using the above-described heating heater 17. Further, in a case where different coating supply sources 6 (a sputtering source, an arc evaporation source, and the like) are provided inside the vacuum chamber 2, these coating supply sources may form an intermediate layer which is positioned between the substrate and the coating deposited by the plasma CVD.

Subsequently, the gas supply unit 9 supplies the process gas into the vacuum chamber 2, so that the pressure inside the vacuum chamber 2 is kept at the pressure of 0.1 to 1000 Pa suitable for the coating process.

With regard to the coating process, when the plasma generation power supply 10 supplies the AC power, a glow discharge is generated between the substrate W held by the rotation holding unit 4 of the first group 18 and the substrate W held by the rotation holding unit 4 of the second group 19. Accordingly, the plasma necessary for the coating process is generated between the substrates W held by the rotation holding units 4 of different groups.

The pressure suitable for the coating process is different depending on the type of CVD coatings to be deposited (the process gases or the reactive gases). In this embodiment, a pressure of about 0.1 Pa to 1000 Pa is preferable. Since the pressure inside the vacuum chamber 2 becomes about 0.1 Pa to 1000 Pa, a stable glow discharge is generated, so that the coating process is performed at a stable coating speed. Furthermore, from the viewpoint of suppressing the production of powder accompanied by the reaction in the gas, the coating pressure is desirably 100 Pa or less.

Further, the voltage of the AC power supplied from the plasma generation power supply 10 is between 300 V to 3000 V (the peak value of the voltages between both output electrodes) necessary for keeping the glow discharge. Furthermore, the AC power supplied from the plasma generation power supply 10 is preferable about 0.05 to 5 W/cm² as the power per unit area.

In this way, the AC voltage and the AC power supplied from the plasma generation power supply 10 are adjusted, and the substrate W is held by the rotation holding unit 4 revolving in a rotating state, so that a stable glow discharge is generated between the substrates W (the adjacent substrates W) held by the rotation holding units 4 adjacent to each other in the circumferential direction about the revolution axis Q. Accordingly, the CVD coating having a uniform coating thickness is deposited on the surface of the substrate W.

When ending the coating process, the output of the plasma generation power supply 10 and the introduction of the process gas stop, and the coating process ends. When the temperature of the substrate W is high, some time is spent until the temperature of the substrate W decreases if necessary. Subsequently, the inside of the vacuum chamber 2 is opened to the atmosphere, and the substrate W is separated from the rotation holding unit 4. In this way, the substrate W having the CVD coating deposited on the surface thereof may be obtained.

As described above, when the rotation holding unit 4 of the first group 18 and the rotation holding unit 4 of the second group 19 having opposite polarities are alternately disposed in the circumferential direction, a difference in potential inevitably occurs between the substrates W held by the rotation holding units 4 adjacent to each other in the circumferential direction. Accordingly, a glow discharge is generated between both rotation holding units. Then, when the positive and negative states of the power supplied from the plasma generation power supply 10 are reversed, the polarities of the rotation holding units 4 adjacent to each other in the circumferential direction are also reversed, and a glow discharge is generated between both rotation holding units. Accordingly, in the plasma CVD apparatus 100, a uniform coating process is performed on plural substrates W at one time.

That is, when the substrate W held by the rotation holding unit 4 of the first group 18 serves as a working electrode so that the CVD coating is deposited on the substrate W, the substrate W held by the rotation holding unit 4 of the second group 19 becomes a counter electrode (an opposite electrode). Then, when the positive and negative states of the power supplied from the plasma generation power supply 10 are reversed, the substrate W held by the rotation holding unit 4 of the second group 19 becomes a working electrode, and the substrate W held by the rotation holding unit 4 of the first group 18 becomes a counter electrode.

### [Effect]

As described above, in the plasma CVD apparatus 100 according to this embodiment, since the substrates W serve also as the counter electrodes for generating the glow discharge, the casing of the vacuum chamber 2 and the revolution table 5 do not become the counter electrodes for generating the glow discharge. Therefore, the components like the revolution table 5 and the vacuum chamber 2 do not serve as the glow discharge generation electrodes for generating the plasma. Accordingly, even when the plasma CVD apparatus 100 is operated for a long period of time so that the insulation coating is deposited on the components like the revolution table 5 and the vacuum chamber 2 in a thick state, the plasma does not become unstable. As a result, the plasma CVD apparatus 100 may stably produce the CVD coating without any non-uniformity in coating quality and thickness. Further, since the components like the revolution table 5 and the vacuum chamber 2 do not serve as the electrodes for generating the glow discharge, the components are not exposed to the plasma that decomposes the source gas. For this reason, a coating is not easily deposited on the components (the revolution table 5, the vacuum chamber 2, and the like) compared to the existing coating apparatus. As a result, flakes caused by heavy deposition of the coating are hardly scattered, and a coating defect is not also easily generated. Furthermore, the coating represented by the DLC containing metal exhibits slight conductivity. However, even in this case, the coating is not easily deposited on the casing and the like of the vacuum chamber 2. For this reason, the scattering of the flakes hardly occurs and the coating defect hardly occurs. Further, even when a coating having some conductivity such as the DLC containing metal is deposited on the substrate, there is a case in which an insulation coating having a poor coating quality is deposited in a chamber portion with weak plasma. In such a case, the effect of preventing the unstable plasma is exhibited.

The above-described first embodiment has been described by exemplifying the most preferable embodiment. The essential point of the technique is that the substrates W disposed on the respective rotation holding units 4 on the revolution table 5 are divided into groups and the period in which the substrate serves as the working electrode of the negative potential that plays primary role to generate the plasma and the period in which the substrate serves as the counter electrode are alternately repeated when the respective groups generate the glow discharge plasma. Accordingly, the component like the vacuum chamber does not become involved with the generation of the plasma. Thus, even when the component is covered by the insulation coating, it is possible to prevent a bad influence in which the plasma becomes unstable.

From such a viewpoint, the scope of the first embodiment is not limited to the plasma CVD apparatus 100 which includes two groups of the rotation holding units 4 connected to both output electrodes of one plasma generation power supply 10. For example, a configuration may be employed in which the rotation holding units 4 are divided into three groups, and the period in which the rotation holding unit 4 of each group serves as the working electrode for generating the glow discharge plasma of the negative potential, the period in which the rotation holding unit serves as the counter electrode, and the period in which the rotation holding unit is separated from the power supply circuit for generating the plasma so as not to contribute to the generation of the plasma are sequentially repeated as different periods. Alternatively, for example, the rotation holding units are divided into three groups. Then, the rotation holding units 4 of the respective groups may repeat the operation in which the rotation holding unit 4 of each group serves as the working electrode for generating the glow discharge plasma of the negative potential with the temporal ratio of 2/3 and the rotation holding unit serves as the counter electrode with the temporal ratio of 1/3. In addition, for example, the rotation holding units 4 may be divided into three groups and the three-phase AC power may be applied to the rotation holding unit 4 of each group.

Further, in the plasma CVD apparatus 100 of this embodiment, six rotation holding units 4 are disposed on the revolution table 5. However, the number of the rotation holding units 4 on the revolution table 5 and the method of arranging the rotation holding units 4 may be set in various ways.

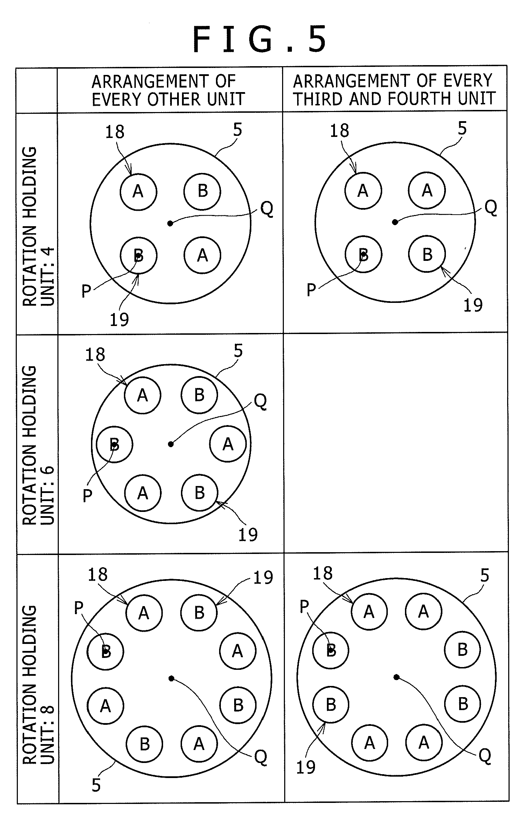

For example, as illustrated in Fig. 5, a case is supposed in which the total number of the rotation holding units 4 is four (the upper stage of Fig. 5) or eight (the lower stage of Fig. 5) in addition to the case in which the total number thereof is six (the middle stage of Fig. 5).

Even in this case, the rotation holding units 4 may be divided into the group (A) in which the rotation holding units belong to the first group 18 and the group (B) in which the rotation holding units belong to the second group 19, and the rotation holding units 4 of the group (A) and the rotation holding units 4 of the group (B) may be (alternately) arranged about the revolution axis Q at every other position. Accordingly, the plasma is generated between the adjacent substrates W in the circumferential direction, and the CVD coating is deposited on the substrate W held by the rotation holding unit 4 in a stable condition (see the left column of Fig. 5).

Further, as illustrated in the right column of Fig. 5, the rotation holding units 4 of the first group 18 and the rotation holding units 4 of the second group 19 may be arranged about the revolution axis Q at every third and fourth position. Even in this arrangement, the plasma having an excellent symmetric property is generated about the revolution axis Q. Accordingly, the CVD coating is deposited on the substrate W held by the rotation holding unit 4 in a stable condition.

Further, the present invention is not limited to the above-described embodiment. Further, the embodiments may be combined with each other and the shapes, the structures, the materials, and the combinations of the respective components may be appropriately modified in the scope without changing the spirit of the present invention. Further, in the embodiment disclosed herein, the items which are not expressly stated, for example, the running condition, the operation condition, various parameters, the dimensions, the weights, and the volumes of the components, and the like do not limit the normal scope implemented by the person skilled in the art. Then, the items which may be easily supposed by the normal person skilled in the art are employed.

### <Second Embodiment>

### [Overall Configuration]

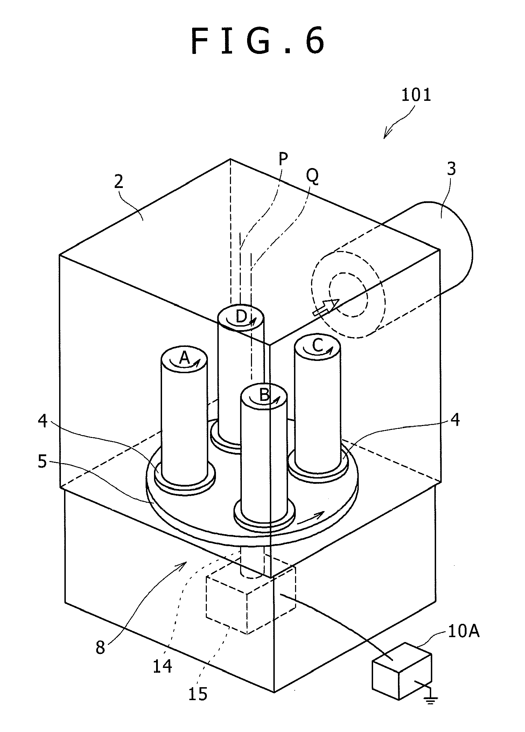

Hereinafter, an AIP (Arc Ion Plating) apparatus as an example of the vacuum coating apparatus of the present invention will be described by referring to Fig. 6. Furthermore, since the description in Figs. 3(a) to 4 is the same as that of the first embodiment, the description will not be repeated herein. Further, the overall configuration of an AIP apparatus 101 is the same as that of Fig. 1 except for the number of the rotation holding units 4.

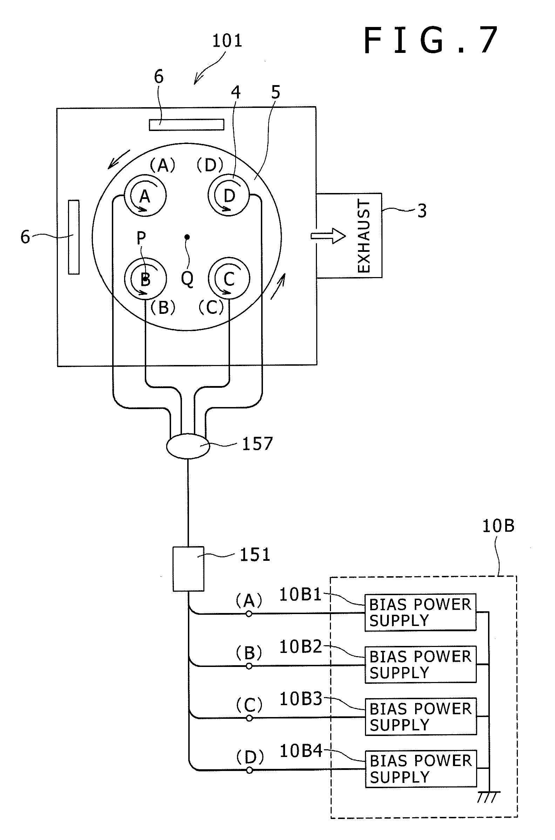

The AIP apparatus 101 includes an evaporation source 6 (here, the arc evaporation source: see Fig. 7) which is disposed inside the vacuum chamber 2 and a power supply unit 10A which may supply (apply) a bias voltage to the respective rotation holding units 4 so that the respective rotation holding units 4 have different potentials. The AIP apparatus 101 deposits a coating on the substrate W held by each rotation holding unit 4 in the same manner as that of the first embodiment through an AIP method.

In the AIP apparatus 101 of this embodiment, the bias voltage is supplied to the respective rotation holding units 4 so that the plural rotation holding units 4 have different potentials. In this way, the AIP apparatus 101 of this embodiment may change the coating condition for each rotation holding unit 4 by changing the bias voltage supplied to each rotation holding unit 4.

Specifically, in a state where four rotation holding units 4 are disposed on the revolution table 5, the respective rotation holding units 4 indicated by "A", "B", "C", and "D" of Fig. 6 are connected to four output electrodes of the power supply unit 10A. The power supply unit 10A may supply the bias voltage to the respective rotation holding units 4 so that the respective rotation holding units 4 have different potentials.

Furthermore, in the AIP apparatus 101 of this embodiment, the bias voltage is supplied to the respective rotation holding units 4 so that the respective rotation holding units 4 have different potentials. For this reason, the brush mechanism is provided in the spinning axis P of each rotation holding unit 4, and the bias voltage is applied to each rotation holding unit 4 through the brush mechanism. The spinning axis P is rotatably held by the revolution table 5 through the bearing mechanism, but the voltage may be applied thereto through the bearing mechanism.

Here, the "state where the respective rotation holding units 4 have different potentials" includes not only the state where each rotation holding unit 4 has a different potential but also the state where the rotation holding units 4 are divided into several groups (for example, two groups and three groups) and each group has a different potential. That is, each group is not limited to the case where each group includes one rotation holding unit 4, and also includes the case where each group includes plural rotation holding units 4. For example, when the rotation holding units 4 indicated by "A", "B", "C", and "D" of Fig. 6 are connected to the power supply unit 10A capable of supplying different bias voltages to the respective rotation holding units 4, the respective rotation holding units 4 have different potentials. Further, in a case where the rotation holding units 4 indicated by "A", "B", "C", and "D" of Fig. 6 are divided into one group (the first group) as "A" and "C" and one group (the second group) as "B" and "D", when the respective rotation holding units 4 are connected to one output electrode of the power supply unit 10A capable of supplying different two bias voltages to the first group and the second group, the rotation holding units 4 of the first group have potentials different from those of the rotation holding units 4 of the second group. Furthermore, the number of the rotation holding units 4 on the revolution table 5 may be six or eight as described below. Further, the rotation holding units 4 may be divided into three or more groups. Further, different bias voltages may be applied to the rotation holding units 4 so that four rotation holding units 4 have different potentials.

The voltage supplied from the bias power supply to the rotation holding unit 4 is a negative constant voltage in many cases. However, the voltage may be a voltage of which value temporary changes, an AC voltage, or a pulsed waveform having an intermittent positive voltage.

Furthermore, the power supply unit 10A is not limited to the above-described configuration. In this embodiment, the bias power supplies are provided as many as the number of the rotation holding units 4 or the number of the groups, and one electrode of each bias power supply is connected to each corresponding rotation holding unit 4. In this case, the other electrode of each bias power supply is grounded. For example, as illustrated in Fig. 7, a power supply unit 10B includes bias power supplies 10B1 to 10B4 which are provided as many as the number (four in Fig. 7) of the rotation holding units 4 mounted on the revolution table 5. One-side electrodes of the bias power supplies 10B1 to 10B4 are connected to fixed brush holders (A) to (D) of the quadrupole slip ring 151. The other-side electrodes of the bias power supplies 10B1 to 10B4 are respectively grounded.

Accordingly, the bias voltage generated by the bias power supply 10B1 is applied to the substrate W held by the rotation holding unit 4 additionally indicated by "A" in Figs. 6 and 7. Further, the bias voltage generated by the bias power supply 10B2 is applied to the substrate W held by the rotation holding unit 4 additionally indicated by "B". Further, the bias voltage generated by the bias power supply 10B3 is applied to the substrate W held by the rotation holding unit 4 additionally indicated by "C". Further, the bias voltage generated by the bias power supply 10B4 is applied to the substrate W held by the rotation holding unit 4 additionally indicated by "D". Here, the power supply unit 10B is not limited to the configuration in which the power supply unit includes the bias power supplies provided as many as the number of the rotation holding units 4 mounted on the revolution table 5 or the number of the groups when the rotation holding units 4 are divided into two or more groups. In the power supply unit, the bias power supply may be provided as one unit if different power may be supplied to each rotation holding unit 4 or each group.

Furthermore, in Fig. 7, the arc evaporation source 6 is described as the coating supply source. Further, the AIP apparatus 101 may employ a configuration in which the substrate W may be heated by the heater or the process gas may be introduced into the vacuum chamber 2. Further, instead of the arc evaporation source 6, a sputtering evaporation source or a crucible evaporation source may be the coating supply source. Further, in a mechanism in which the respective rotation holding units 4 revolve in a rotating state, the respective rotation axes (the respective spinning axis P and the revolution axis Q) extend in the vertical direction, but the extension directions of the respective rotation axes are not limited. For example, the above-described mechanism may be provided so that the respective rotation axes extend in the horizontal direction.

### [Coating Process]

In the AIP apparatus 101, the bias voltage is supplied to the respective rotation holding units 4 so that the respective rotation holding units 4 have different potentials. For this reason, in the AIP apparatus 101, a coating process is performed while a different bias voltage is applied to each rotation holding unit 4 during the coating process. In this way, the AIP apparatus 101 may apply a different bias voltage to each rotation holding unit 4 during the coating process. Accordingly, in the AIP apparatus 101, the coating qualities of the coatings deposited on the substrates W are different in the respective rotation holding units 4 having different bias voltages. For example, in a case of depositing a hard coating by TiN, TiAlN, or the like according to the AIP method, when a high negative bias voltage (for example, -150 V to 300 V) and a low negative bias voltage (for example, -10 V to -100 V) are applied to each rotation holding unit 4, a coating having a different stress level may be deposited by a single coating process.

Further, in the AIP apparatus 101, since a different bias voltage may be applied to each rotation holding unit 4 during the coating process, a different heat input condition may be obtained for each rotation holding unit 4. For example, in the AIP apparatus 101, when depositing a hard coating by TiN, TiAlN, or the like according to the AIP method, a high negative bias voltage is applied to the rotation holding unit 4 holding the substrate W having a relatively high thermal capacity and a low negative bias voltage is applied to the rotation holding unit 4 holding the substrate W having a relatively low thermal capacity. Accordingly, in the AIP apparatus 101, even when the substrates W having different thermal capacities are mounted on the revolution table 5 together, a process may be performed at the constant temperature as the same (single) coating process.

Further, in an ion bombardment process (a process in which a negative high voltage is applied to a surface while irradiating metal ions thereto from an arc evaporation source so as to clean the surface) performed before the coating process, a different bias voltage is applied to each rotation holding unit 4, so that the heat input condition at the ion bombardment process may be different for each rotation holding unit 4 having a different bias voltage. For example, in the AIP apparatus 101, when depositing a hard coating by TiN, TiAlN, or the like according to the AIP method, a high negative bias voltage is applied to the rotation holding unit 4 that holds the substrate W of which the temperature hardly increases. Further, a low negative bias voltage is applied to the rotation holding unit 4 that mounts (holds) thereon a small-diameter high-speed steel drill of which the substrate becomes easily softened by an increase in temperature. Accordingly, a process having a sufficient bombardment effect is performed on a large-diameter tool while preventing overheat of a substrate of which the temperature easily increases by the same (single) ion bombardment process.

As described above, in any case, in the apparatus of the related art, the process is performed plural separate times, but in the AIP apparatus 101 according to this embodiment, the process may be performed only once.

### [Vacuum Coating Method]

The entire process of the coating method using the AIP apparatus 101 with the above-described configuration is as below. Furthermore, as described above, the AIP apparatus 101 includes the arc evaporation source 6 as the coating supply source.

### (1) Setting of Substrate W to Vacuum Exhaust

First, a case will be supposed in which a coating is actually deposited by the AIP method using the AIP apparatus 101 illustrated in Figs. 6 and 7. In the AIP apparatus 101, four rotation holding units 4 are disposed about the revolution axis Q at the interval of 90° in the circumferential direction on the revolution table 5 disposed inside the vacuum chamber 2.

First, the substrate W is installed on the rotation holding unit 4. The substrate W may be fixed onto the rotation holding unit 4 or may be placed on the rotation holding unit 4 by the installation jig 13.

When the substrate W is prepared in this way, the vacuum pump 3 (the vacuum exhaust unit 3) performs an exhaust operation until the inside of the vacuum chamber 2 becomes a high vacuum state.

### (2) Heating (Optional Process)

If necessary, the substrate W is preheated by a radiation heating mechanism (a heater) inside the vacuum chamber 2. At this time, the AIP apparatus 101 revolves the respective rotation holding units 4 about the revolution axis Q as the rotation axis and rotates each rotation holding unit 4 about the spinning axis P as the rotation axis.

### (3) Ion Bombardment Process

The coating supply source which is mounted on the AIP apparatus 101 is the arc evaporation source 6. The AIP apparatus 101 generates an arc discharge in the arc evaporation source 6 and applies a negative bias voltage of several hundreds of V to 1500 V to the substrate W so as to clean the surface of the substrate W. At this time, the AIP apparatus 101 revolves the respective rotation holding units 4 about the revolution axis Q as the rotation axis and rotates each rotation holding unit 4 about the spinning axis P as the rotation axis.

The AIP apparatus 101 may apply a different bias voltage to each rotation holding unit 4 so that the respective rotation holding units 4 have different potentials during the ion bombardment process. Further, the AIP apparatus 101 may adjust the cleaning degree and the temperature increase degree for each rotation holding unit 4. For this reason, the AIP apparatus 101 may perform an ion bombardment process so as to satisfy each appropriate condition when the substrates W requiring different process conditions exist together in the ion bombardment process.

### (4) Coating

The AIP apparatus 101 generates an arc discharge in the arc evaporation source 6. Then, the AIP apparatus 101 deposits a coating while introducing a reactive gas (nitrogen or the like) into the vacuum chamber 2 and applying a negative bias voltage of several tens of V to 300 V to the substrate W. At this time, the AIP apparatus 101 revolves the respective rotation holding units 4 about the revolution axis Q as the rotation axis and rotates each rotation holding unit 4 about the spinning axis P as the rotation axis.

The AIP apparatus 101 may apply a different bias voltage to each rotation holding unit 4 so that the respective rotation holding units 4 have different potentials during the coating process. The AIP apparatus 101 may adjust the temperature of the substrate W and the coating quality of the coating deposited on the substrate W held by the rotation holding unit 4 for each rotation holding unit 4 by changing the application condition of the bias voltage to the rotation holding unit 4. For this reason, in the AIP apparatus 101, even when the substrates requiring different process conditions exist together, it is possible to perform a coating process satisfying each appropriate condition. Further, in a process of searching for the process condition, a coating may be deposited by various conditions during a single coating process, and hence a time necessary for searching for the process condition may be shortened.

### [Effect]

As described above, according to the AIP apparatus 101 of this embodiment, it is possible to apply a different bias voltage to each rotation holding unit 4 or each group when the rotation holding units 4 are divided into two or more groups. For this reason, according to the AIP apparatus 101, a coating having a different stress level may be deposited by the same (single) process. Further, according to the AIP apparatus 101, a constant temperature process may be performed by the same (single) process when processing the substrate W while the substrates W having different thermal capacities exist together. Further, according to the AIP apparatus 101, it is possible to perform an ion bombardment process having a sufficient bombardment effect on the substrate W of which the temperature hardly increases while preventing overheat of the substrate W that may be easily overheated by the same (single) process. In the apparatus of the related art, since the process needs to be performed as plural separate processes, the efficiency is largely improved compared to the apparatus of the related art in the case of the AIP apparatus 101 of this embodiment.

### <Third Embodiment>

Hereinafter, an AIP apparatus 102 as an example of the vacuum coating apparatus of the present invention will be described. Furthermore, since the description of Figs. 3(a) to Fig. 4 is the same as that of the first embodiment, the description thereof will not be repeated herein. Further, the overall configuration of the AIP apparatus 102 is the same as that of Fig. 1 except for the number of the rotation holding units 4.

### [Overall Configuration]

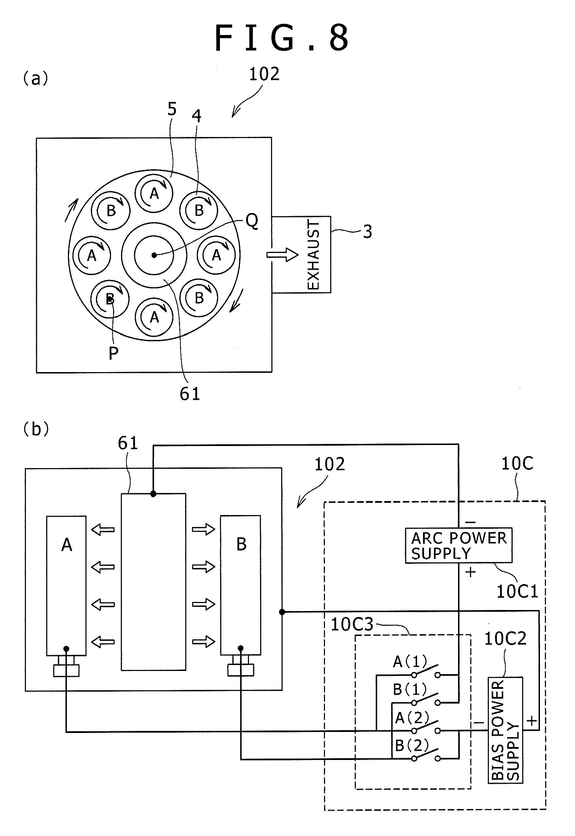

Figs. 8(a) and 8(b) illustrate a power supply connection example of the AIP apparatus 102. The AIP apparatus 102 includes a cylindrical arc evaporation source 61. Further, in the AIP apparatus 102, eight rotation holding units 4 are mounted on the revolution table 5. The eight rotation holding units 4 are divided into the group A and the group B. The cylindrical arc evaporation source 61 is provided about the center of the vacuum chamber 2 so as to be surrounded by the eight rotation holding units 4.

Furthermore, the vacuum exhaust unit (the vacuum pump) 3 may perform an exhaust operation until the inside of the vacuum chamber 2 becomes a vacuum state. The cylindrical arc evaporation source 61 is provided at the center portion of the vacuum chamber 2. Further, the AIP apparatus 102 may perform a heating operation by a heater (not illustrated) and a process gas introduction (not illustrated) by the coating process.

In the AIP apparatus 102, a power supply unit 10C feeds power to the substrate W. The power supply unit 10C includes an arc power supply 10C1, a bias power supply 10C2, and a selection switch 10C3. The symbol "A" of Fig. 8(b) indicates four rotation holding units 4 which are additionally indicated by "A" illustrated in Fig. 8(a). Further, the symbol "B" of Fig. 8(b) indicates four rotation holding units 4 which are additionally indicated by "B" illustrated in Fig. 8(a).

In the AIP apparatus 102, the rotation holding units 4 of the group A and the rotation holding units 4 of the group B are connected to the anode of the arc power supply 10C1 or the cathode of the bias power supply 10C2 by the selection switch 10C3. The power supply unit 10C and the selection switch 10C3 will be described.

Since the selection switch 10C3 is operated, it becomes a state (an arc power supply connection state) in which each rotation holding unit 4 of the group A is connected to the anode of the arc power supply 10C1 so as to become a potential in which each rotation holding unit serves as the anode of the arc evaporation source 6, and it becomes a state (a bias power supply connection state) in which each rotation holding unit 4 of the group B is connected to the cathode of the bias power supply 10C2 so as to become a potential in which each rotation holding unit controls the energy of the incoming ions to the substrate W. Then, when a predetermined time elapses in this state, each rotation holding unit 4 of the group A is switched from the arc power supply connection state to the bias power supply connection state and each rotation holding unit 4 of the group B is switched from the bias power supply connection state to the arc power supply connection state. Furthermore, when a predetermined time elapses in this state, each rotation holding unit 4 of the group A is switched from the bias power supply connection state to the arc power supply connection state and each rotation holding unit 4 of the group B is switched from the arc power supply connection state to the bias power supply connection state. The selection switch 10C3 repeats the switching of the connection state.

### [Coating Process]

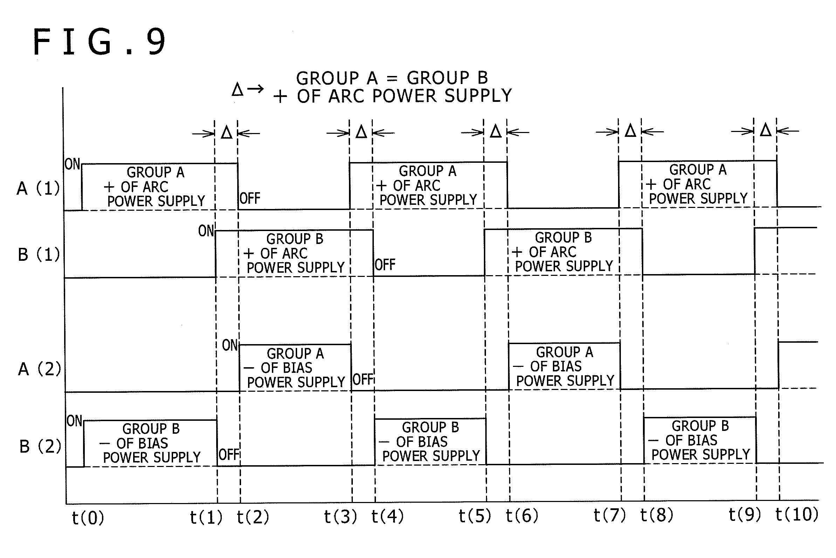

A coating process different from that of the first embodiment during the entire process of the coating method using the AIP apparatus 102 with the above-described configuration will be described by referring to Fig. 9. Fig. 9 is a timing chart illustrating the operation of the selection switch 10C3 during the coating process.

At the time t(0), the selection switch 10C3 connects a switch A(1) and connects a switch B(2). At this time, a switch B(1) and a switch A(2) are broken. The period from the time t(0) to the time t(1) is set as a first state. Generally, the period from the time t(4N - 4) to the time t(4N - 3) is the first state. Furthermore, N = 1, 2, 3,....

In the first state, the substrate W held by the rotation holding unit 4 of the group A is connected to the anode of the arc power supply 10C1. Accordingly, the substrate W of the group A serves as the anode of the arc discharge, and the arc discharge is generated between the cylindrical arc evaporation source 61 and the substrate W held by the rotation holding unit 4 of the group A. Further, the substrate W held by the rotation holding unit 4 of the group B is connected to the cathode of the bias power supply 10C2. Accordingly, the bias voltage is applied to the substrate W held by the rotation holding unit 4 of the group B. At this time, since the respective rotation holding units 4 revolve about the revolution axis Q (the cylindrical arc evaporation source 61) while rotating about the respective spinning axes P in a state where the substrates W are held by the respective rotation holding units, the substrate W held by the rotation holding unit 4 of the group A and the substrate W held by the rotation holding unit 4 of the group B are exposed to the steam from the cylindrical arc evaporation source 61, so that a coating is deposited. At this time, a coating is deposited on the substrate W held by the rotation holding unit 4 of the group A while the bias voltage is not applied to the substrate and a coating is deposited on the substrate W held by the rotation holding unit 4 of the group B while the bias voltage is applied to the substrate.

At the time t(1), the selection switch 10C3 breaks the switch B(2) and connects the switch B(1). Accordingly, the substrate W held by the rotation holding unit 4 of the group B is connected to the anode of the arc power supply 10C1. Subsequently, at the time t(2), the selection switch 10C3 breaks the switch A(1) and connects the switch A(2).

From the viewpoint of the stability of the arc discharge, as described above, it is preferable that the period in which the switch A(1) is connected slightly overlaps the period in which the switch B(1) is connected (the period from the time t(1) to the time t(2)).

The period from the time t(2) to the time t(3) is set as a second state. Generally, the period from the time t(4N - 2) to the time t(4N - 1) is the second state. Furthermore, N = 1, 2, 3,....

In the second state, the substrate W held by the rotation holding unit 4 of the group B is connected to the anode of the arc power supply 10C1. Accordingly, the substrate W held by the rotation holding unit 4 of the group B serves as the anode of the arc discharge, and the arc discharge is generated between the cylindrical arc evaporation source 61 and the substrate W held by the rotation holding unit 4 of the group B. The substrate W held by the rotation holding unit 4 of the group A is connected to the cathode of the bias power supply 10C2. Accordingly, the bias voltage is applied to the substrate W held by the rotation holding unit 4 of the group A. At this time, since the respective rotation holding units 4 revolve about the revolution axis Q (the cylindrical arc evaporation source 61) while rotating about the respective spinning axes P in a state where the respective rotation holding units hold the substrates W, the substrate W held by the rotation holding unit 4 of the group A and the substrate W held by the rotation holding unit 4 of the group B are exposed to the steam from the cylindrical arc evaporation source 61, so that a coating is deposited. At this time, a coating is deposited on the substrate W held by the rotation holding unit 4 of the group B while the bias voltage is not applied to the substrate, and a coating is deposited on the substrate W held by the rotation holding unit 4 of the group A while the bias voltage is applied to the substrate.

At the time t(3), the selection switch 10C3 breaks the switch A(2) and connects the switch A(1). Accordingly, the substrate W held by the rotation holding unit 4 of the group A is connected to the anode of the arc power supply 10C1. Subsequently, at the time t(4), the selection switch 10C3 breaks the switch B(1) and connects the switch B(2). From the viewpoint of the stability of the arc discharge, as described above, it is preferable that the period in which the switch A(1) is connected slightly overlap the period in which the switch B(1) is connected (the period from the time t(3) to the time t(4)).

As described above, among the substrate W held by the rotation holding unit 4 of the group A and the substrate W held by the rotation holding unit 4 of the group B on the revolution table 5, the substrates W held by the rotation holding units 4 of at least one group become a potential in which the substrates serve as the anode of the arc discharge. That is, in the AIP apparatus 102, any substrate W normally serves as the anode of the arc discharge. For this reason, the AIP apparatus 102 may stably keep the arc discharge even when the anode for the arc discharge is not separately provided. Then, a coating is deposited on the substrate W kept at the potential of the bias voltage so as to have a coating quality controlled by the application of the bias voltage during the arc discharge.

Incidentally, a coating is deposited on the substrate W kept at the potential of the anode, that is, the substrate W serving as the anode of the arc discharge while the bias voltage is not applied to the substrate. However, since the bias voltage is applied to the substrate W at a predetermined cycle, the coating quality may be controlled by the bias voltage during the control period. Then, the applied bias voltage is set in consideration of the period (the time) in which the substrate W becomes a potential for causing the substrate to serve as the anode of the arc discharge. Accordingly, a coating of a desired coating quality is deposited.

From the viewpoint of the coating quality, when a coating having a thickness larger than 100 nm is deposited while the bias voltage is not applied, the weakness of the layer severely influences the entire coating quality, and hence this becomes a problem. Desirably, when the thickness of the coating continuously growing during the period (the time) in which the substrate W has a potential for causing the substrate to serve as the anode of the arc discharge is equal to or smaller than 10 nm, the concern on the coating quality is reduced. Further, it is preferable to shorten the switching time as fast as possible from the viewpoint of the coating quality. However, from the viewpoint of the easiness of switching the large current output from the arc power supply, a problem arises at the frequency of which the switching period exceeds 1 kHz, and hence the frequency is equal to or smaller than 100 Hz from the actual viewpoint.

From the description above, when the time (see) necessary for depositing a coating of 100 nm on the substrate during the coating process is denoted by t, the switching period T(sec) desirably satisfies the inequation of t > T > 1 msec.

Such a cycle is repeated. Since the first state and the second state are alternately repeated, a coating is deposited on both the substrates W held by the rotation holding unit 4 of the group A and the substrate W held by the rotation holding unit 4 of the group B according to the AIP method.

Furthermore, in the description above, a case has been exemplified in which the coating is deposited according to the AIP method, but the present invention is not limited to the case in which the coating is deposited according to this method. For example, the coating may be deposited by using a sputtering evaporation source as an evaporation source.

### [Effect]

In the existing coating apparatus, plural rotation holding units have the same potential. For this reason, in a case where the bias voltage is applied in order to control the coating quality, the anodes disposed around the cylindrical arc evaporation source are essentially needed. When the anodes exist, the steam from the cylindrical arc evaporation source adheres to the anodes. Accordingly, the coating speed decreases, so that the productivity is degraded. Also, the coatings deposited on the anodes are peeled off, so that a defect of the coating occurs. On the contrary, in the AIP apparatus 102 of this embodiment, such problems do not occur. Specifically, the problems are as below.

In the AIP apparatus 102 of this embodiment, the substrates W held by the rotation holding units 4 of at least one group among the substrates W held by the rotation holding units 4 of the group A and the substrates W held by the rotation holding units 4 of the group B on the revolution table 5 become a potential in which the substrates may serve as the anodes of the arc discharge. That is, in the AIP apparatus 102, any substrate W normally serves as the anode of the arc discharge. For this reason, the AIP apparatus 102 may stably keep the arc discharge even when the anode for the arc discharge is not separately provided. In this way, in the AIP apparatus 102 of this embodiment, since bar-shaped anodes for an arc discharge do not need to be provided around the cylindrical arc evaporation source 61, the steam (the evaporated coating raw material) from the cylindrical arc evaporation source 61 moving toward the substrate W is not disturbed by the anodes for the arc discharge. Further, the coating raw material deposited on the electrodes for the arc discharge does not need to be cleaned. For this reason, in the AIP apparatus 102 of this embodiment, the productivity is improved compared to the coating apparatus of the related art.

Furthermore, the potential of each rotation holding unit 4 does not need to abruptly change between the anode potential of the arc discharge and the bias potential and may change to the bias potential after a floating state or a grounded state.

Further, the bias voltage does not need to be uniform at all times. In particular, when the switching period is relatively long, it is preferable to apply a pulsed voltage of a period sufficiently faster than the switching period.

Further, in this embodiment, the rotation holding units 4 are divided into two groups, but the number of the groups is not limited to two. The rotation holding units 4 may be divided into more groups. In this case, the AIP apparatus is configured so that the rotation holding units 4 of at least one group (or one rotation holding unit 4) serve as the anode of the arc discharge at any timing.

### [Outline of Embodiments]

The above-described embodiments may be summarized as below.

That is, the vacuum coating apparatus according to the above-described embodiment is a vacuum coating apparatus including: a vacuum chamber; a vacuum exhaust unit that performs a vacuum exhaust operation inside the vacuum chamber; a plurality of rotation holding units that have a plurality of rotation axes set so as to be parallel to one another and hold a substrate as a coating subject while rotating about the respective rotation axes; and a revolution mechanism that revolves the plurality of rotation holding units about a revolution axis parallel to the rotation axes of the respective rotation holding units, wherein the plurality of rotation holding units are divided into a plurality of groups so that power is supplied to the respective rotation holding units in a manner that the rotation holding units of the respective groups have different potentials.

According to such a configuration, power is supplied to the respective the rotation holding units so that the rotation holding units of the respective groups have different potentials. For this reason, even when the coating apparatus is used for a long period of time, a stable coating process may be performed, and a coating is hardly deposited on a portion other than the substrate, so that the productivity is improved. Further, even when the coating conditions are different, the coating process may be uniformly performed on plural substrates at one time, and hence the productivity is improved.

Further, the vacuum coating apparatus may be used to generate a plasma in a gas supplied into the vacuum chamber by a voltage applied to the rotation holding units, and may alternately repeat a state where the rotation holding unit of each group have a negative potential causing the rotation holding units to serve as a working electrode that plays primary role to generate a glow discharge plasma and a state where the rotation holding units of each group serves as a counter electrode of the working electrode as the power supplied to the respective rotation holding units is changed for each group.

According to such a configuration, the casing of the vacuum chamber and the revolution table do not become the counter electrodes for generating the glow discharge. Therefore, the components like the revolution table and the vacuum chamber do not serve as the glow discharge generation electrodes for generating the plasma. Accordingly, even when the plasma CVD apparatus is operated for a long period of time so that the insulation coating is deposited on the components like the revolution table and the vacuum chamber in a thick state, the plasma does not become unstable. As a result, the plasma CVD apparatus may stably produce the CVD coating without any non-uniformity in coating quality and thickness. Further, since the components like the revolution table and the vacuum chamber do not serve as the electrodes for generating the glow discharge, the components are not exposed to the plasma that decomposes the source gas. For this reason, a coating is not easily deposited on the components (the revolution table, the vacuum chamber, and the like) compared to the coating apparatus of the related art. As a result, flakes caused by the thick sedimentation of the coating are hardly scattered, and a coating defect is not also easily generated.

Further, the vacuum coating apparatus may further include a plasma generation power supply that supplies power to the rotation holding units of each group and generates a plasma in a source gas supplied into the vacuum chamber, wherein the plurality of rotation holding units may be divided into any one of a first group in which the rotation holding units are connected to one electrode of the plasma generation power supply and a second group in which the rotation holding units are connected to the other electrode of the plasma generation power supply, and power supplied to the rotation holding units of each group may be switched so that the first group and the second group are alternately switched.

According to such a configuration, when the rotation holding units of the respective groups generate the glow discharge plasma, the period in which the rotation holding units serve as the working electrodes of the negative potentials that play primary role to generate the plasma and the period in which the rotation holding units serve as the counter electrodes are alternately repeated. Accordingly, the component like the vacuum chamber does not become involved with the generation of the plasma. Thus, even when the component is covered by the insulation coating, it is possible to prevent a bad influence in which the plasma becomes unstable.

Further, the revolution mechanism may include a revolution table that is rotatable about the revolution axis, and the plurality of rotation holding units may be respectively disposed so as to be lined up at the same interval in the circumferential direction about the revolution axis on the revolution table. In this state, the number of the rotation holding units belonging to the first group may be equal to that of the rotation holding units belonging to the second group, and the rotation holding units of the first and second groups may be lined up in the circumferential direction at every other position. Accordingly, the plasma is generated between the substrates adjacent to each other in the circumferential direction, and hence the CVD coating is deposited on the substrate held by the rotation holding unit in a stable condition.

Further, the number of the rotation holding units belonging to the first group may be equal to that of the rotation holding units belonging to the second group, and the rotation holding units of the first and second groups may be lined up in the circumferential direction at every third and fourth position. Even in this arrangement, the plasma having an excellent symmetric property is generated about the revolution axis. Accordingly, the CVD coating is deposited on the substrate W held by the rotation holding unit in a stable condition.

The vacuum coating apparatus may further include a bias power supply, and the bias power supply may supply power to the respective rotation holding units so that the rotation holding units of the respective groups have different potentials.

Further, the vacuum coating apparatus may further include an evaporation source; an evaporation source power supply that supplies power to the evaporation source so that the evaporation source works as a cathode; and a bias power supply that supplies a bias voltage to the substrate held by the rotation holding unit, wherein the plurality of rotation holding units may be divided into at least two groups, and wherein the rotation holding units of each group may alternately repeat a state where the rotation holding units are connected to an anode of the evaporation source power supply and a state where the rotation holding units are connected to the bias power supply, and the rotation holding units of at least one group may serve as anodes of the evaporation source.

According to such a configuration, the substrates held by the rotation holding units of at least one group of plural groups on the revolution table become the potential for causing the substrates to serve as the anodes of the arc discharge between the evaporation source and the substrates. That is, according to the above-described configuration, any substrate normally serves as the anode of the arc discharge. For this reason, the vacuum coating apparatus may stably keep the arc discharge between the evaporation source and the substrate without separately providing the anode for the arc discharge. In this way, in the vacuum coating apparatus with the above-described configuration, since bar-shaped anodes for the arc discharge do not need to be separately provided around the evaporation source, the steam (the evaporated coating raw material) from the evaporation source moving toward the substrate is not disturbed by the anodes for the arc discharge. Further, the coating raw material deposited on the anodes for the arc discharge does not need to be cleaned. For this reason, the vacuum coating apparatus with the above-described configuration improves the productivity compared to the coating apparatus of the related art.

In this case, in a state where the rotation holding units of one group are connected to the anode of the evaporation source power supply, the rotation holding units of another group may be connected to the anode of the evaporation source power supply, and then the connection between the rotation holding units of the one group and the anode of the evaporation source power supply may be broken, so that a time is provided in which power is supplied from the anode of the evaporation source power supply to both the rotation holding units of the one group and the rotation holding units of the other group.

According to such a configuration, it is possible to reliably prevent a state where there is no substrate having a potential causing the substrate to serve as the anode of the arc discharge at the switching timing. Accordingly, the arc discharge becomes stable.

### INDUSTRIAL APPLICABILITY

The present invention provides a vacuum coating apparatus.

## Claims

1. A vacuum coating apparatus (100) that deposits a coating on a substrate (W), the vacuum coating apparatus (100) comprising:
a vacuum chamber (2);
a vacuum exhaust unit (3) that performs a vacuum exhaust operation inside the vacuum chamber (2);
a plurality of rotation holding units (4) that have a plurality of rotation axes set so as to be parallel to one another and hold the substrate (W) as a coating subject while rotating about the respective rotation axes; and
a revolution mechanism (8) that revolves the plurality of rotation holding units (4) about a revolution axis (Q) parallel to the rotation axes of the respective rotation holding units (4),
wherein the plurality of rotation holding units (4) are divided into a plurality of groups so that power is supplied to the respective rotation holding units (4) in a manner that the rotation holding units (4) of the respective groups have different potentials,
wherein the vacuum coating apparatus (100) is used to generate a plasma in a gas supplied into the vacuum chamber (2) by a voltage applied to the rotation holding units (4), and alternately repeats a state where the rotation holding units (4) of each group (18, 19, A, B) have a negative potential causing the rotation holding units (4) to serve as a working electrode that plays primary role to generate a glow discharge plasma and a state where the rotation holding units (4) of each group (18, 19, A, B) serve as a counter electrode of the working electrode, as the power supplied to the respective rotation holding units (4) is changed for each group (18, 19, A, B).

2. The vacuum coating apparatus (100) according to claim 1, further comprising:
a plasma generation power supply (10) that supplies power to the rotation holding units (4) of each group (18, 19, A, B) and generates a plasma in a source gas supplied into the vacuum chamber (2),
wherein the plurality of rotation holding units (4) are divided into any one of a first group (18, A) in which the rotation holding units (4) are connected to one output electrode of the plasma generation power supply (10) and a second group (19, B) in which the rotation holding units (4) are connected to the other output electrode of the plasma generation power supply (10), and power supplied to the rotation holding units (4) of each group (18, 19, A, B) is switched so that the first group (18, A) and the second group (19, B) are alternately switched.

3. The vacuum coating apparatus (100) according to claim 2,
wherein the revolution mechanism (8) includes a revolution table (5) that is rotatable about the revolution axis (Q), and
wherein the plurality of rotation holding units (4) are respectively disposed so as to be lined up at the same interval in the circumferential direction about the revolution axis (Q) on the revolution table (5).

4. The vacuum coating apparatus (100) according to claim 3,
wherein the number of the rotation holding units (4) belonging to the first group (18, A) is equal to that of the rotation holding units (4) belonging to the second group (19, B), and the rotation holding units (4) of the first and second groups (18, 19, A, B) are lined up in the circumferential direction at every other position.

5. The vacuum coating apparatus (100) according to claim 3,
wherein the number of the rotation holding units (4) belonging to the first group (18, A) is equal to that of the rotation holding units (4) belonging to the second group (19, B), and the rotation holding units (4) of the first and second groups (18, 19, A, B) are lined up in the circumferential direction at every third and fourth position.

## Patentansprüche

1. Vakuumbeschichtungsgerät (100), das eine Beschichtung an einem Substrat (W) niederschlägt, wobei das Vakuumbeschichtungsgerät (100) Folgendes aufweist:
eine Vakuumkammer (2);
eine Vakuumauslasseinheit (3), die einen Vakuumauslassbetrieb im Inneren der Vakuumkammer (2) durchführt;
eine Vielzahl von Rotationshalteeinheiten (4), die eine Vielzahl von Rotationsachsen haben, die so festgelegt sind, dass sie parallel zueinander sind und das Substrat (W) als einen Beschichtungsgegenstand halten, während es um die jeweiligen Rotationsachsen rotiert;
einen Kreisbewegungsmechanismus (8), der die Vielzahl von Rotationshalteeinheiten (4) um eine Kreisbewegungsachse (Q), die parallel zu den Rotationsachsen der jeweiligen Rotationshalteeinheiten (4) verläuft, kreisen lässt,
wobei die Vielzahl von Rotationshalteeinheiten (4) in eine Vielzahl von Gruppen geteilt sind, so dass Leistung zu den jeweiligen Rotationshalteeinheiten (4) in einer solchen Art zugeführt wird, dass die Rotationshalteeinheiten (4) der jeweiligen Gruppen verschiedene Potentiale haben,
wobei das Vakuumbeschichtungsgerät (100) dazu verwendet wird, ein Plasma in einem in die Vakuumkammer (2) zugeführten Gas durch eine auf die Rotationshalteeinheiten (4) aufgebrachte Spannung zu erzeugen, und einen Zustand, in welchem die Rotationshalteeinheiten (4) einer jeden Gruppen (18, 19, A, B) ein negatives Potential haben, das die Rotationshalteeinheiten (4) dazu bringt, als eine Arbeitselektrode zu dienen, die eine primäre Rolle beim Erzeugen eines Glimmentladungsplasmas spielt, und einen Zustand, in welchem die Rotationshalteeinheiten (4) einer jeden Gruppe (18, 19, A, B) als eine Gegenelektrode der Arbeitselektrode dienen, wenn die zu den jeweiligen Rotationshalteeinheiten (4) zugeführte Leistung für jede Gruppe (18, 19, A, B) geändert wird, alternierend wiederholt.

2. Vakuumbeschichtungsgerät (100) gemäß Anspruch 1, ferner mit
einer Plasmaerzeugungsleistungszufuhr (10), die Leistung zu den Rotationshalteeinheiten (4) einer jeden Gruppe (18, 19, A, B) zuführt und ein Plasma in einem in die Vakuumkammer (2) zugeführten Quellengas erzeugt,
wobei die Vielzahl von Rotationshalteeinheiten (4) in eine erste Gruppe (18, A) in welcher die Rotationshalteeinheiten (4) mit einer Abgabeelektrode der Plasmaerzeugungsleistungszufuhr (10) verbunden sind, und eine zweite Gruppe (19, B) geteilt sind, in welcher die Rotationshalteeinheiten (4) mit der anderen Abgabeelektrode der Plasmaerzeugungsleistungszufuhr (10) verbunden sind, und wobei zu den Rotationshalteeinheiten (4) einer jeden Gruppe (18, 19, A, B) zugeführte Leistung derart umgeschaltet wird, dass die erste Gruppe (18, A) und die zweite Gruppe (19, B) abwechselnd umgeschaltet werden.

3. Vakuumbeschichtungsgerät (100) gemäß Anspruch 2,
wobei der Kreisbewegungsmechanismus (8) einen Kreisbewegungstisch (5) aufweist, der um die Kreisbewegungsachse (Q) drehbar ist, und
wobei die Vielzahl von Rotationshalteeinheiten (4) jeweils so angeordnet sind, dass sie bei dem gleichen Intervall in der Umfangsrichtung um die Kreisbewegungsachse (Q) an dem Kreisbewegungstisch (5) aufgereiht sind.

4. Vakuumbeschichtungsgerät (100) gemäß Anspruch 3,
wobei die Anzahl der Rotationshalteeinheiten (4), die zu der ersten Gruppe (18, A) gehören, gleich wie jene der Rotationshalteeinheiten (4) ist, die zu der zweiten Gruppe (19, B) gehören, und die Rotationshalteeinheiten (4) der ersten und zweiten Gruppen (18, 19, A, B) bei jeder anderen Position in der Umfangsrichtung aufgereiht sind.

5. Vakuumbeschichtungsgerät (100) gemäß Anspruch 3,
wobei die Anzahl der Rotationshalteeinheiten (4), die zu der ersten Gruppe (18, A) gehören, gleich wie jene der Rotationshalteeinheiten (4) ist, die zu der zweiten Gruppe (19, B) gehören, und die Rotationshalteeinheiten (4) der ersten und zweiten Gruppen (18, 19, A, B) bei jeder dritten und vierten Position in der Umfangsrichtung aufgereiht sind.

## Revendications

1. Dispositif de revêtement sous vide (100) qui dépose un revêtement sur un substrat (W), le dispositif de revêtement sous vide (100) comprenant :
une chambre sous vide (2) ;
une unité d'évacuation sous vide (3) qui effectue une opération d'évacuation sous vide à l'intérieur de la chambre sous vide (2) ;
une pluralité d'unités de support de rotation (4) qui comprennent une pluralité d'axes de rotation configurés de façon à être parallèles les uns aux autres et qui tiennent le substrat (W) en tant qu'objet du revêtement tout en tournant autour des axes de rotation respectifs ; et
un mécanisme de révolution (8) qui fait tourner la pluralité des unités de support de rotation (4) autour d'un axe de révolution (Q) parallèle aux axes de rotation des unités de support de rotation respectives (4),
dans lequel la pluralité d'unités de support de rotation (4) est divisée en une pluralité de groupes de sorte que le courant soit fourni aux unités de support de rotation respectives (4) d'une manière telle que les unités de support de rotation (4) des groupes respectifs présentent des potentiels différents,
dans lequel le dispositif de revêtement sous vide (100) est utilisé pour générer un plasma dans un gaz fourni à l'intérieur de la chambre sous vide (2) par une tension appliquée aux unités de support de rotation (4) et répète de manière alternée un état où les unités de support de rotation (4) de chaque groupe (18, 19, A, B) ont un potentiel négatif entraînant les unités de support de rotation (4) à servir d'électrode opérationnelle qui joue un rôle principal pour générer un plasma de décharge luminescente et un état où les unités de support de rotation (4) de chaque groupe (18, 19, A, B) servent de contre-électrode de l'électrode opérationnelle, au fur et à mesure que le courant fourni aux unités de support de rotation respectives (4) est modifié pour chaque groupe (18, 19, A, B).

2. Dispositif de revêtement sous vide (100) selon la revendication 1, comprenant en outre :
une alimentation électrique de génération de plasma (10) qui fournit un courant aux unités de support de rotation (4) de chaque groupe (18, 19, A, B) et génère un plasma dans un gaz source fourni à l'intérieur de la chambre sous vide (2),
dans lequel la pluralité d'unités de support de rotation (4) est divisée en un quelconque premier groupe (18, A) dans lequel les unités de support de rotation (4) sont reliées à une électrode de sortie de l'alimentation électrique de génération de plasma (10) et en un second groupe (19, B) dans lequel les unités de support de rotation (4) sont reliées à l'autre électrode de sortie de l'alimentation électrique de génération de plasma (10) et le courant fourni aux unités de support de rotation (4) de chaque groupe (18, 19, A, B)est commuté de sorte que le premier groupe (18, A) et le second groupe (19, B) soit commutés en alternance.

3. Dispositif de revêtement sous vide (100) selon la revendication 2,
dans lequel le mécanisme de révolution (8) comprend une table de révolution (5) qui peut être pivotée autour de l'axe de révolution (Q), et
dans lequel une pluralité d'unités de support de rotation (4) sont agencées respectivement de façon à être alignées à un intervalle identique suivant la direction circonférentielle autour de l'axe de révolution (Q) sur la table de révolution (5).

4. Dispositif de revêtement sous vide (100) selon la revendication 3,
dans lequel le nombre d'unités de support de rotation (4) appartenant au premier groupe (18, A) est égal à celui des unités de support de rotation (4) appartenant au second groupe (19, B) et les unités de support de rotation (4) du premier et du second groupe (18, 19, A, B) sont alignées suivant la direction circonférentielle une position sur deux.

5. Dispositif de revêtement sous vide (100) selon la revendication 3,
dans lequel le nombre d'unités de support de rotation (4) appartenant au premier groupe (18, A) est égal à celui des unités de support de rotation (4) appartenant au second groupe (19, B) et les unités de support de rotation (4) du premier et du second groupe (18, 19, A, B) sont alignées suivant la direction circonférentielle à chaque troisième et quatrième position.
